# EUROPEAN PATENT SPECIFICATION

(11) **EP 2 859 624 B1**
(45) Date of publication and mention of the grant of the patent: **01.08.2018**
(21) Application number: 12818907.3
(22) Date of filing: 17.10.2012
(51) Int. Cl.: H01R 13/627, H01R 13/635, G02B 6/42

(54) **HEAT DISSIPATION WITH AN ON-BOARD CONNECTOR**
WÄRMEABLEITUNG MIT EINEM LEITERPLATTENVERBINDER
DISSIPATION DE CHALEUR AU MOYEN D'UN CONNECTEUR EMBARQUÉ

(30) Priority: 12.06.2012 WO PCT/IB2012/001644
(43) Date of publication of application: 15.04.2015
(73) Proprietor: Amphenol FCI Asia Pte. Ltd., Singapore 368328 (SG)
(72) Inventor: KEIL, Ulrich, 13509 Berlin (DE)
(74) Representative: De Vries & Metman
(86) International application number: PCT/IB2012/002419
(87) International publication number: WO 2013/186589

(56) References cited:
- US-A1- 2004 027 816
- US-A1- 2009 296 350

## Description

### FIELD OF THE DISCLOSURE

The invention relates to the field of heat dissipation with on-board connectors, such as electrical or optical connectors.

### BACKGROUND OF THE DISCLOSURE

Appropriate heat management with electronic or opto-electronic components has a direct effect to their reliability and performance. Electronic and opto-electronic components typically have strict temperature requirements for optimal operation. Overheating of an electronic or opto-electronic component within an (opto)electronic system my affect the entire system.

Also optical transceivers need to be cooled to improve their performance. An optical transceiver is typically configured to transmit and receive optical signals to and from a complementary optical connector via optically active devices, such as a light-emitting device and a light-receiving device. Such a transceiver generally includes a main body encasing electronic components, electronic circuitry and a receptacle receiving the optical connector.

Such electrical or opto-electric components are generally used in configurations with a source of cooling air, such as servers, more particular high density servers and rack-mountable servers, typically provided with one or more cooling fans.

To dissipate heat from electronic or opto-electronic components heat sinks can be employed, particularly if available space is limited. Heat sinks typically comprise a heat sink base coupled to an electronic or opto-electronic component, and a plurality of parallel heat sink pins or fins extending upwardly from the heat sink base. The heat sink base acts as the primary conduction path for heat generated by the electronic component. The heat sink pins or fins dissipate heat and create turbulence in air blown through the heat sink pins. An example of a heat sink for an on-board connector is disclosed in US 20090296350.

Although good results can be obtained with the use of such heat sinks, it is an object to further improve heat dissipation by electronic and opto-electronic components.

### SUMMARY OF THE DISCLOSURE

In an aspect of the invention a method is provided for dissipating heat from an electronic or opto-electronic connector comprising a heat sink with a heat sink base carrying a plurality of upwardly extending elements. Cooling air is blown to the heat sink in a direction making an angle with the top surface of the heat sink base, viewed in side view. In other words, the air flow direction makes an angle with the plane of the top surface of the heat sink base, in a vertical plane parallel to the air flow direction.

The elements can for instance be pins, such as an array of pins extending under right angles with the heat sink base. Alternatively, or additionally, the heat dissipation elements may include fins and/or similar elements.

It has been found that heat dissipation is substantially improved, e.g., almost doubled if the air flow angle relative to the heat sink is increased from 0 degrees to about 30 degrees. Accordingly, good results are obtained if the angle between air flow direction and the top surface of the heat sink base in side view is 45 degrees or lower, e.g., 30 degrees or lower. Preferably, the angle between the air flow direction and the top surface of the heat sink base in side view is at least 4 degrees.

Further an assembly is disclosed comprising at least one board connector on a substrate within the scope of a cooling air flow. The board connector has a top surface at least partly covered with a heat sink comprising a heat sink base having a top surface carrying a plurality of upwardly extending heat dissipation elements, such as pins. The top surface of the heat sink base is inclined under an angle towards the air flow.

The source of the air flow can be any air displacing device, such as a blower or a fan, in particular a regular cooling fan in a server, such as a high density server.

The air flow angle can be increased by tilting the air flow and/or by tilting the heat sink. Good results are obtained if a board connector is used with a top face, making a top face angle of 0 - 30 degrees with the substrate in side view. Preferably, the top face angle is at least 5 degrees relative to the substrate.

The board connector can for example be an optical transceiver configured to receive a complementary optical cable connector. For further improvement of heat dissipation the transceiver may for instance comprise at least one thermo-conductive bridge between a heat generating component in the transceiver and the transceiver top face.

### BRIEF DESCRIPTION OF THE DRAWINGS

The drawings show embodiments of an optical transceiver by way of example, the drawings being explained in more detail below.
Figure 1: shows schematically an optical transceiver with a heat sink and a source for cooling air;
Figure 2: shows the transceiver of Figure 1 in perspective view;
Figure 3; shows an alternative transceiver in perspective view;
Figure 4; shows a graph of thermal resistance as a function of the air flow angle.

### DETAILED DESCRIPTION OF EMBODIMENTS

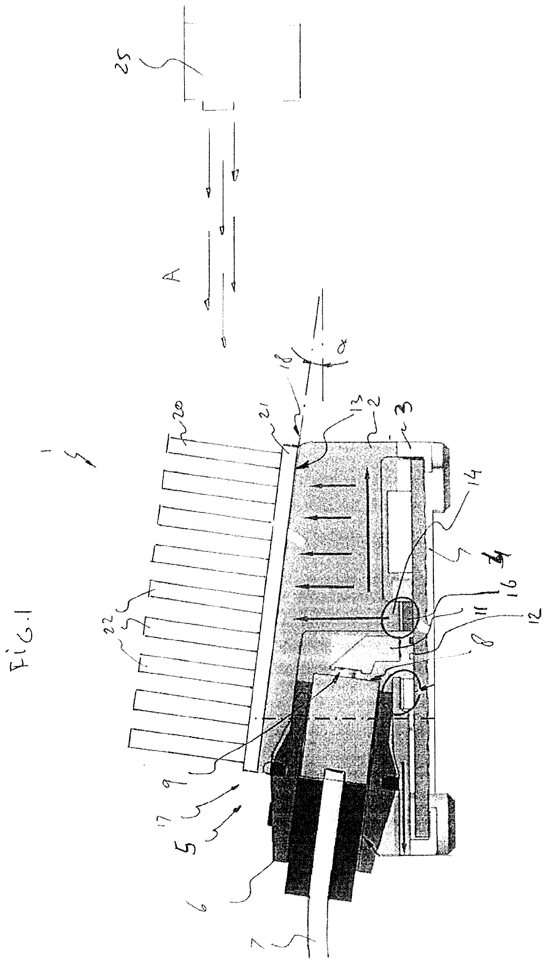

Figure 1 shows an on-board connector 1 with an optical transceiver 2. The optical transceiver 2 is received in a socket 3 on a board 4. The transceiver 2 comprises a receiving opening 5 for receiving a complementary cable connector 6 connected to a cable 7 holding a plurality of optical fibers. The cable connector 6 has a contact face 8 presenting the fiber ends of the optical fibers to a complementary contact face 9 of a coupler element 11 encased in the transceiver 2. Optical signals from the fiber ends are received via contact face 9 of the coupler 11 and guided downwardly to opto-electronic elements 12 transforming the optical signals to electronic signals. The transceiver 2 comprises a thermo-conductive top face 13 and thermo-conductive bridges 14 between the top face and heat generating electronic elements 16 of the transceiver 2.

The top face 13 of the transceiver 2 slopes from a high edge 17 at the side of the cable entry 5 to a lower edge 18 at the opposite side. In side view the top face 13 makes an angle α of, e.g., about 5 - 10 degrees, e.g., about 7 degrees with the plane of the board 4.

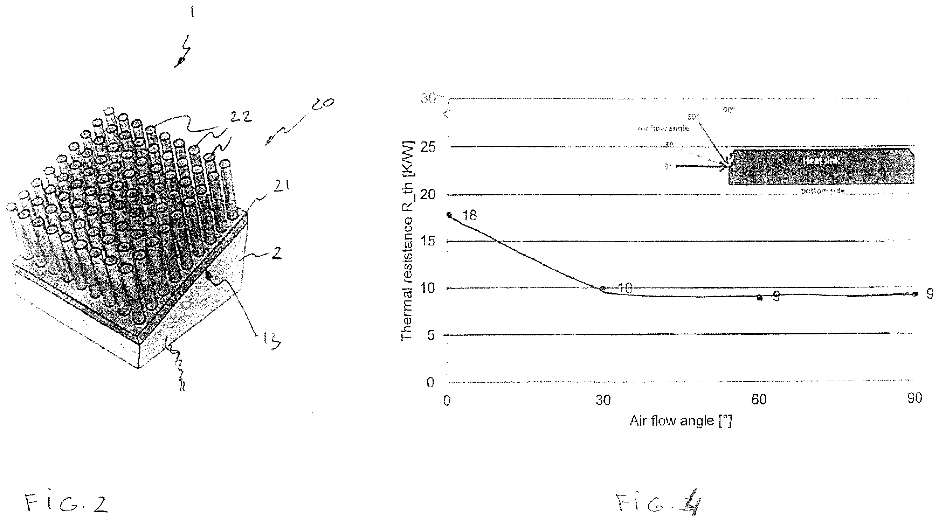

A heat sink 20 covers the top face 13 of the transceiver 2. The heat sink 20 comprises a flat heat sink base 21 of uniform thickness carrying an array of equidistantly arranged upwardly extending heat dissipating pins 22 (see Figure 2). In the shown embodiment, the pins 22 are substantially perpendicular to the heat sink base 21.

The heat sink 20 can for instance be made of a metal or a similar heat dissipating material. The heat sink base can for example be attached to the transceiver top face 13 using a thermo-conductive adhesive.

Figure 1 schematically indicates a source of cooling air 25 generating a flow of air in a flow direction indicated by arrows A. The cooling air source 25 will generally be a regular cooling fan or similar provision as typically used with high density or rack-mountable servers. Alternatively the sources can comprise any other type of blower or air displacement device positioned at a distance from the transceiver facing the lower edge 18 of the slanting top face 13. Cooling air is blown from the cooling air source 25 through the plurality of pins 22 to take up excessive heat. In the embodiment shown in the drawing, the direction A is substantially horizontal, so the angle between the air flow direction A and the heat sink base 21 is equal to the slanting angle of the top face 13, which is 7 degrees.

Heat is generated by the various opto-electronic components 12, 16 in the transceiver 2. The generated heat is dissipated via the thermoconductive bridges 14 and the top face 13 to the heat sink 20. The heat sink 20 dissipates heat via the pins 22 to the surrounding air. The heat dissipation is substantially increased by forcing a flow of cooling air through the array of pins 22.

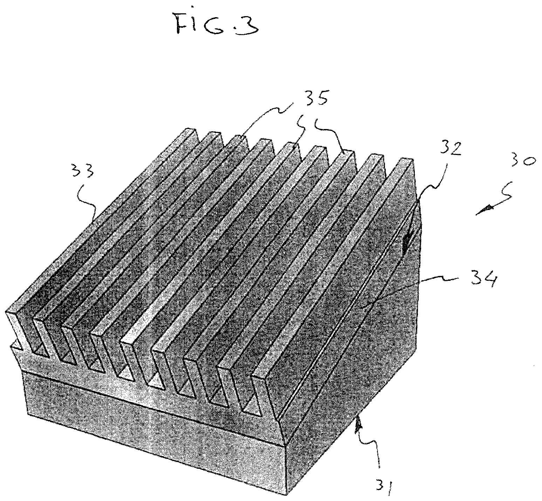

Figure 3 shows an alternative embodiment of a transceiver 30 with a bottom surface 31 and a slanting top surface 32. The top surface 32 is capped with a heat sink 33 comprising a heat sink base 34 plating the top surface 32 of the transceiver 30 and carrying a row of parallel and equidistantly spaced cooling fins 35. Any other type or configuration of upwardly extending cooling elements can also be used, if so desired. Generally, the bottom surface 31 is parallel to the substrate and to the flow direction of cooling air. The top surface 32 of the transceiver 30 and the heat sink base 34 make an angle with the bottom surface 31 and, correspondingly, with the air flow direction.

The graph in Figure 4 shows the thermal resistance of the heat sink as a function of the angle α between the air flow A and the heat sink base 21. More precisely, the air flow angle in the graph is the angle between the air flow direction A and the heat sink base 21 in a vertical plane parallel to the air flow direction A. Thermal resistance is a measure (Kelvins per Watt) of a temperature difference by which an object or material resists a heat flow and indicates the temperature difference across the thermal interface as a function of dissipated power on one side of the interface. Thermal resistance is inversely proportional to thermal conductance. A lower thermal resistance results in a proportionally higher heat dissipation.

The graph in Figure 3 makes clear that the thermal resistence is reduced with almost 50% when the flow angle is increased from 0 to about 30 degrees. This means that the temperature difference between the air and the heat sink is halved.

Further increase of the air flow angle α does not have substantial effect on the thermal resistance.

In the embodiment of Figure 1 the air flow direction A is substantially horizontal and the angle α between the heat sink base 21 and the air flow is obtained by using a transceiver 2 with a slanting top face 13. Alternatively, or additionally, the angle α between the air flow and the heat sink base 21 can also be increased by generating a non-horizontal air flow making an angle with the horizontal and/or by tilting the transceiver 2 as a whole.

## Claims

1. Method to dissipate heat from an electronic or optoelectronic component (1, 30) positioned within the scope of a cooling air flow (A), wherein the electronic or optoelectronic component comprises a heat sink (20, 33) with a heat sink base (21, 34) having a top surface carrying a plurality of upwardly extending heat dissipation elements (22, 35), **characterized in that** the top surface makes an angle (α) with the flow direction of the cooling air flow.

2. Method according to claim 1 wherein the upwardly extending elements of the heat sink (20, 33) include pins (22) and/or fins (35).

3. Method according to claim 2 wherein the pins (22) and/or fins (35) are under right angles with the heat sink base (21, 34) .

4. Method according to any one of the preceding claims wherein the angle (α) between the air flow direction (A) and the top surface of the heat sink base (21, 34) in side view is 0 < α ≤ 45 degrees, e.g., 0 < α ≤ 30 degrees.

5. Method according to claim 4 wherein the angle (a) between the air flow direction (A) and the top surface of the heat sink base (21, 34) in side view is at least 4 degrees.

6. Assembly comprising at least one board connector (1, 30) on a substrate (4) and a cooling air source (25) generating a flow of cooling air in a flow direction (A), wherein the board connector has a top surface (13, 32) at least partly covered with a heat sink (20, 33) comprising a heat sink base (21, 34) having a top surface carrying a plurality of upwardly extending heat dissipation elements (22, 35), **characterized in that** the air flow is directed under an angle (α) with the top surface of the heat sink base.

7. Assembly according to claim 6 wherein the board connector in side view has a top surface (13, 32) that makes an angle (α) of 30 degrees or less with the substrate.

8. Assembly according to claim 7 wherein the board connector in side view has a top surface (13, 32) that makes an angle (α) of at least 4 degrees with the substrate (4).

9. Assembly according to claim 8 wherein the board connector comprises an optical transceiver (2, 30) configured to receive a complementary optical cable connector.

10. Assembly according to claim 8 or 9 wherein the board connector comprises at least one thermo-conductive bridge (14) between a heat generating component in the connector and the connector top face (13, 32).

## Patentansprüche

1. Verfahren zum Abführen von Wärme von einer elektronischen oder optoelektronischen Komponente (1, 30), die innerhalb des Bereichs einer Kühlluftströmung (A) positioniert ist, wobei die elektronische oder optoelektronische Komponente eine Wärmesenke (20, 33) mit einer Wärmesenkenbasis (21, 34) aufweist, die eine obere Oberfläche hat (20, 33) hat, die mehrere sich aufwärts erstreckende Wärmeabführungselemente (22, 35) hat,
**dadurch gekennzeichnet, dass** die obere Oberfläche einen Winkel (α) mit der Strömungsrichtung der Kühlluftströmung bildet.

2. Verfahren nach Anspruch 1, wobei die sich aufwärts erstreckenden Elemente der Wärmesenke (20, 33) Stifte und/oder Rippen (35) aufweisen.

3. Verfahren nach Anspruch 2, wobei die Stifte (22) und/oder Rippen (35) in rechten Winkeln zu der Wärmesenkenbasis (21, 34) stehen.

4. Verfahren nach einem der vorhergehenden Ansprüche, wobei der Winkel (α) zwischen der Luftströmungsrichtung (A) und der oberen Oberfläche der Wärmesenkenbasis (21, 34) in der Seitenansicht 0 < α ≤ 45 Grad, z.B. 0 < α ≤ 30 Grad, ist.

5. Verfahren nach Anspruch 4, wobei der Winkel (a) zwischen der Luftströmungsrichtung (A) und der oberen Oberfläche der Wärmesenkenbasis (21, 34) in der Seitenansicht wenigstens 4 Grad ist.

6. Anordnung, die wenigstens einen Leiterplattenverbinder (1, 30) auf einem Substrat (4) und eine Kühlluftquelle (25), die eine Strömung von Kühlluft in einer Strömungsrichtung (A) erzeugt, aufweist, wobei der Leiterplattenverbinder eine obere Ober-fläche (13, 32) hat, die wenigstens teilweise mit einer Wärmesenke (20, 33) bedeckt ist, die eine Wärmesenkenbasis (21, 34) mit einer oberen Oberfläche aufweist, die mehrere sich aufwärts erstreckende Wärmeabführungselemente (22, 35) trägt, **dadurch gekennzeichnet, dass** die Luftströmung unter einem Winkel (α) mit der oberen Oberfläche der Wärmesenke ausgerichtet ist.

7. Anordnung nach Anspruch 6, wobei der Leiterplattenverbinder in der Seitenansicht eine obere Oberfläche (13, 32) hat, die einen Winkel (α) von 30 Grad oder weniger mit dem Substrat bildet.

8. Anordnung nach Anspruch 7, wobei der Leiterplattenverbinder in der Seitenansicht eine obere Oberfläche (13, 32) hat, die einen Winkel (α) von wenigstens 4 Grad mit dem Substrat (4) bildet.

9. Anordnung nach Anspruch 8, wobei der Leiterplattenverbinder einen optischen Transceiver (2, 30) aufweist, der dafür konfiguriert ist, einen komplementären optischen Kabelverbinder aufzunehmen.

10. Anordnung nach Anspruch 8 oder 9, wobei der Leiterplattenverbinder wenigstens eine wärmeleitende Brücke (14) zwischen einer wärmeerzeugenden Komponente in dem Verbinder und der Verbinderoberseite (13, 32) aufweist.

## Revendications

1. Procédé pour dissiper la chaleur d'un composant électronique ou optoélectronique (1, 30) positionné à la portée d'un flux d'air de refroidissement (A), dans lequel le composant électronique ou optoélectronique comprend un dissipateur de chaleur (20, 33) avec une base de dissipateur de chaleur (21, 34) présentant une surface supérieure portant une pluralité d'éléments de dissipation de chaleur s'étendant vers le haut (22, 35),
**caractérisé en ce que** la surface supérieure forme un angle (α) avec la direction de flux du flux d'air de refroidissement.

2. Procédé selon la revendication 1, dans lequel les éléments s'étendant vers le haut du dissipateur de chaleur (20, 33) incluent des broches (22) et/ou des ailettes (35).

3. Procédé selon la revendication 2, dans lequel les broches (22) et/ou ailettes (35) sont positionnées selon des angles droits avec la base de dissipateur de chaleur (21, 34).

4. Procédé selon l'une quelconque des revendications précédentes, dans lequel l'angle (α) entre la direction de flux d'air (A) et la surface supérieure de la base de dissipateur de chaleur (21, 34) en vue de côté est de 0 < α ≤ 45 degrés, par exemple 0 < α ≤ 30 degrés.

5. Procédé selon la revendication 4, dans lequel l'angle (a) entre la direction de flux d'air (A) et la surface supérieure de la base de dissipateur de chaleur (21, 34) en vue de côté est d'au moins 4 degrés.

6. Ensemble comprenant au moins un connecteur de carte (1, 30) sur un substrat (4) et une source d'air de refroidissement (25) générant un flux d'air de refroidissement dans une direction de flux (A), dans lequel le connecteur de carte présente une surface supérieure (13, 32) couverte au moins partiellement avec un dissipateur de chaleur (20, 33) comprenant une base de dissipateur de chaleur (21, 34) présentant une surface supérieure portant une pluralité d'éléments de dissipation de chaleur s'étendant vers le haut (22, 35), **caractérisé en ce que** le flux d'air est dirigé sous un angle (α) avec la surface supérieure de la base de dissipateur de chaleur.

7. Ensemble selon la revendication 6, dans lequel le connecteur de carte en vue de côté présente une surface supérieure (13, 32) qui forme un angle (α) de 30 degrés ou moins avec le substrat.

8. Ensemble selon la revendication 7, dans lequel le connecteur de carte en vue de côté présente une surface supérieure (13, 32) qui forme un angle (α) d'au moins 4 degrés avec le substrat (4).

9. Ensemble selon la revendication 8, dans lequel le connecteur de carte comprend un émetteur-récepteur optique (2, 30) configuré pour recevoir un connecteur de câble optique complémentaire.

10. Ensemble selon la revendication 8 ou 9, dans lequel le connecteur de carte comprend au moins un pont thermoconducteur (14) entre un composant de génération de chaleur dans le connecteur et la face supérieure de connecteur (13, 32).
